# EUROPEAN PATENT APPLICATION

(11) **EP 1 020 896 A1**
(43) Date of publication of application: **19.07.2000**
(21) Application number: 00300040.3
(22) Date of filing: 06.01.2000
(51) Int. Cl.: H01L 21/02, H01L 21/3205, H01L 21/8242

(54) **Integrated circuit device with composite oxide dielectric**

(30) Priority: 13.01.1999 US 115769 P; 25.06.1999 US 344785
(71) Applicant: LUCENT TECHNOLOGIES INC., Murray Hill, New Jersey 07974-0636 (US)
(72) Inventor: Merchant, Sailesh Mansinh, Orlando, Florida 32835 (US); Roy, Pradip Kumar, Orlando, Florida 32819 (US)
(74) Representative: Johnston, Kenneth Graham

(57) **Abstract**

An integrated circuit device includes a semiconductor substrate (10) and a first metal oxide layer (15) adjacent the substrate. The first metal oxide layer may be formed of tantalum oxide, for example. A second metal oxide layer (17), which includes an oxide with a relatively high dielectric constant such as titanium oxide, zirconium oxide, or ruthenium oxide, is formed on the first metal oxide layer opposite the semiconductor substrate, and a metal nitride layer (19), such as titanium nitride, is formed on the metal oxide layer opposite the first metal oxide layer. The metal nitride layer includes a metal which is capable of reducing the first metal oxide layer. Thus, the second metal oxide layer substantially blocks reduction of the first metal oxide layer by the metal of the metal nitride layer.

## Description

### Related Application

This application is based upon prior filed copending provisional application No. 60/115,769 filed January 13, 1999.

### Field of the Invention

The present invention relates to the field of integrated circuits, and, more particularly, to integrated circuit devices with a dielectric layer.

### Background of the Invention

Typically, in a metal oxide semiconductor (MOS) transistor, a thin layer of silicon dioxide is grown in the gate region. The oxide functions as a dielectric whose thickness is chosen specifically to allow induction of a charge in the channel region under the oxide. The gate controls the flow of current through the device. In sub-0.5 m technologies, ultra-thin gate oxides are used for ultra-large-scale-integration (ULSI, more than 10 million transistors per chip).

Also, highly integrated memory devices, such as dynamic-random-access-memories (DRAMs), require a very thin dielectric film for the data storage capacitor. To meet this requirement, the capacitor dielectric film thickness will be below 2.5 nm of SiO₂ equivalent thickness. Use of a thin layer of a material having a higher relative permittivity, e.g. Ta₂O₅, in place of the conventional SiO₂ or Si₃N₄ layers is useful in achieving desired performance.

A chemical vapor deposited (CVD) Ta₂O₅ film can be used as a dielectric layer for this purpose, because the dielectric constant of Ta₂O₅ is approximately three times that of a conventional Si₃N₄ capacitor dielectric layer. However, one drawback associated with the Ta₂O₅ dielectric layer is undesired leakage current characteristics. Accordingly, although Ta₂O₅ material has inherently higher dielectric properties, Ta₂O₅ typically may produce poor results due to leakage current. For example, U.S. Patent No. 5,780,115 to Park et al., discloses the use of Ta₂O₅ as the dielectric for an integrated circuit capacitor with the electrode layer being formed of titanium nitride (TiN). However, at temperatures greater than 600 C, this layered structure has a stability problem because the titanium in the TiN layer tends to reduce the Ta₂O₅ of the dielectric layer into elemental tantalum.

### Summary of the Invention

In view of the foregoing background, it is therefore an object of the invention to provide a low leakage, high quality gate or capacitor dielectric.

It is a further object of the invention to prevent the reduction of the dielectric by the metal of the conductor layer.

These and other objects, features and advantages in accordance with the present invention are provided by a semiconductor device including a first metal oxide layer, e.g. a tantalum oxide layer, adjacent a substrate, and a second metal oxide layer on the first metal oxide layer opposite the semiconductor substrate. A metal nitride layer, which includes a metal that may be capable of reducing the first metal oxide layer, is on the second metal oxide layer opposite the first metal oxide layer. The second metal oxide layer substantially blocks reduction of the first metal oxide layer by the metal of the metal nitride layer.

The first metal oxide layer may be tantalum pentoxide and the second metal oxide layer may preferably be titanium dioxide. Also, the second metal oxide layer may be zirconium dioxide, or ruthenium dioxide and preferably has a dielectric constant greater than about 25.

The substrate may comprise silicon and have a channel region therein beneath the first metal oxide layer to define a transistor in combination with the gate provided by the metal nitride layer. Furthermore, a silicon oxide layer between the substrate and the first metal oxide layer may be present and together with the substrate, may define an interface with respective substantially stress-free regions adjacent the interface. Alternatively, the device may include a conductive layer, e.g. a metal layer, between the substrate and the first metal oxide layer to define a capacitor with the metal nitride layer. Such a capacitor may include a silicon oxide layer between the conductive layer and the first metal oxide layer, and an insulating layer between the substrate and the conductive layer.

### Brief Description of the Drawings

FIG. 1 is a schematic cross-sectional view of an integrated circuit device in accordance with the present invention;
FIG. 2 is a schematic cross-sectional view of a transistor in accordance with the present invention;
FIG. 3 is a schematic cross-sectional view of a capacitor in accordance with the present invention; and
FIGS. 4-8 are schematic cross-sectional views of the steps in accordance with the fabrication method of the present invention.

### Detailed Description of the Preferred Embodiments

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

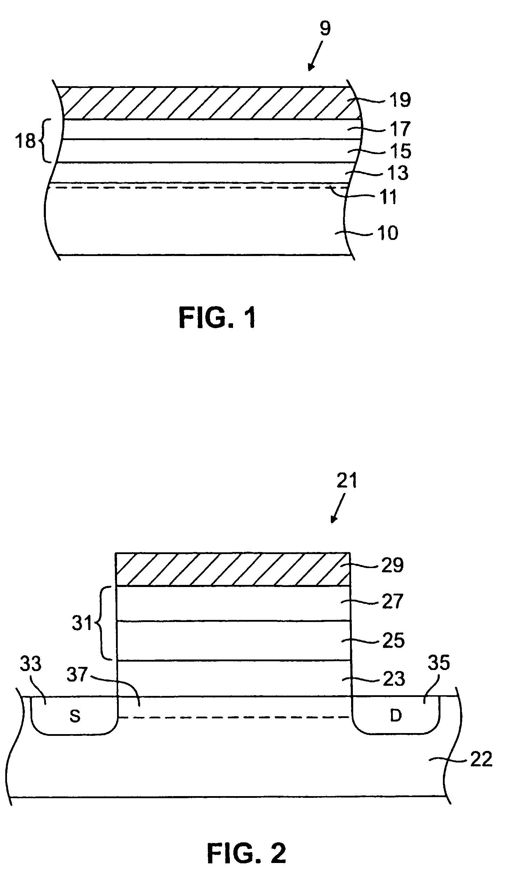

The basic layers of an integrated circuit device **9** according to the present invention will be described with reference to FIG. 1. The device **9** includes a substrate **10** which is made of silicon, for example. An insulation layer **13,** typically silicon dioxide, is disposed on the substrate **10.** Next, the device **9** includes a first metal oxide layer **15** and a second metal oxide layer **17** on the insulation layer **13.** The first metal oxide layer **15** can be formed of, for example, tantalum pentoxide (Ta₂O₅), while the second metal oxide layer **17** includes a metal oxide with a relatively high dielectric constant ( ), for example, greater than about 25. Such a high dielectric metal oxide preferably includes titanium dioxide (TiO₂), and also includes zirconium dioxide (ZrO₂) and ruthenium dioxide (RuO₂), for example. The first and second metal oxide layers form a high- composite dielectric stack **18.**

The device **9** includes a metal nitride layer **19** on the second metal oxide layer **17.** The metal nitride layer **19** may include titanium nitride (TiN) of which the titanium is capable of breaking down or reducing the metal oxide, e.g. tantalum pentoxide, of the first metal oxide layer **15** into, for example, elemental tantalum, as discussed above. However, the high dielectric second metal oxide layer **17** substantially blocks the breakdown or reduction of the metal oxide of the first metal oxide layer by the metal of the metal nitride layer **19.** Thus, the device is stable at temperatures over 600 C and the use of the high- composite dielectric stack **18** allows scaling for sub-0.25 m devices without tunneling or breakdown.

Additionally, the device **9** may include a second silicon dioxide layer **11** to define an essentially planar and stress-free interface between the substrate **10** and the insulation layer **13.** The interface traps defects resulting in the reduction of the defect densities of the insulation layer **13** and substrate **10.**

A transistor **21** incorporating the high- composite dielectric stack of the present invention, as a gate dielectric, will be described with reference to FIG. 2. The transistor **21** includes a substrate **22** having a source **33,** drain **35** and a channel region **37** therein, as would readily be appreciated by the skilled artisan. An insulation layer **23** is disposed above the channel region **37.** The transistor includes a high- composite dielectric stack **31** made up of first and second metal oxide layers **25** and **27.** Again, the first metal oxide layer **25** can be formed of Ta₂O₅, while the second metal oxide layer **27** includes a metal oxide with a relatively high dielectric constant such as TiO₂, ZrO₂ and RuO₂.

The transistor **21** includes a metal nitride layer **29** on the second metal oxide layer **27.** The metal nitride layer **29** may include TiN of which the titanium is capable of breaking down or reducing the metal oxide, e.g. tantalum pentoxide, of the first metal oxide layer **25** into, for example, elemental tantalum, as discussed above. However, the high dielectric second metal oxide layer **27** substantially blocks the breakdown or reduction of the metal oxide of the first metal oxide layer **25** by the metal of the metal nitride layer **29.**

The transistor may also include an essentially planar and stress-free interface between the substrate **22** and the insulation layer **23.** This interface would be formed as described below with reference to the device of FIG. 1.

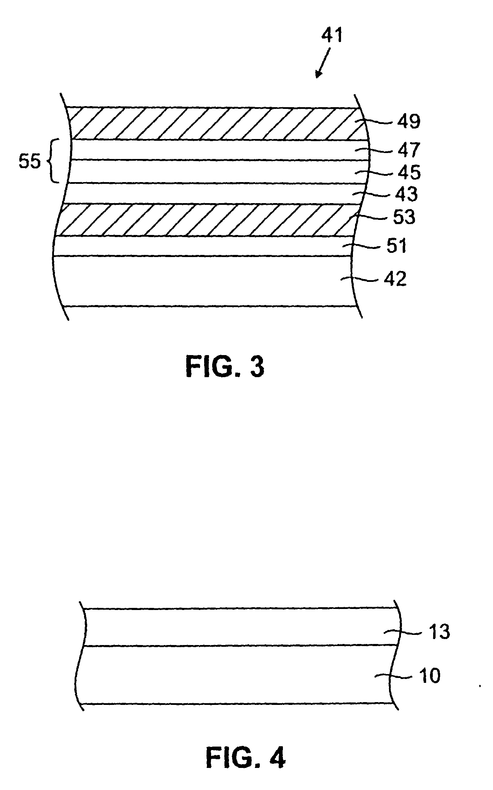

Next, a metal-oxide-metal (MOM) capacitor **41** incorporating the high- composite dielectric stack of the present invention, as a capacitor dielectric, will be described with reference to FIG. 3. The capacitor **41** includes a substrate **42,** a first insulation layer **51** and a first metal conductive layer **53,** as would readily be appreciated by the skilled artisan. A second insulation layer **43** is disposed on the first conductive layer **53.** The capacitor **41** includes a high- composite dielectric stack **55** made up of first and second metal oxide layers **45** and **47.** Again, the first metal oxide layer **45** can be formed of Ta₂O₅, while the second metal oxide layer **47** includes a metal oxide with a relatively high dielectric constant such as TiO₂, ZrO₂ and RuO₂.

The capacitor **41** includes a second metal conductive layer **49** which includes a metal nitride, such as TiN, of which the titanium is capable of breaking down or reducing the metal oxide of the first metal oxide layer **45,** as discussed above. However, the high dielectric second metal oxide layer **47** substantially blocks the breakdown or reduction of the metal oxide of the first metal oxide layer **45** by the metal of the second conductive layer **49.**

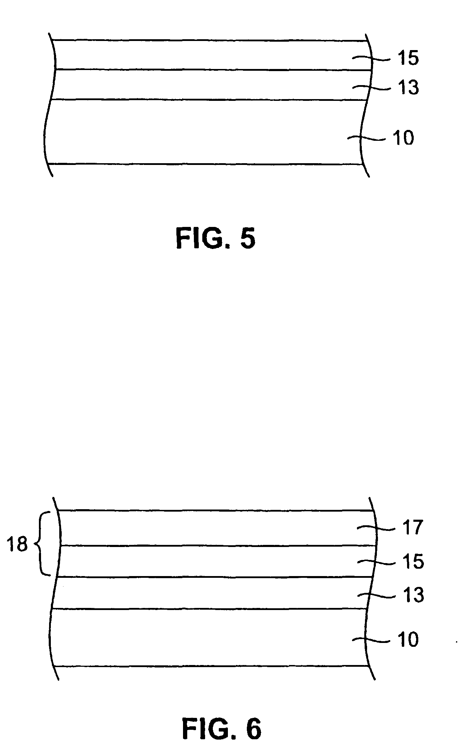

A description of a method of fabricating an integrated device, such as the device **9** of FIG. 1, including a high-composite dielectric stack will be described with reference to FIGS. 4-8. As illustrated in FIG. 4, a silicon substrate **10** is provided and an insulation layer **13** is grown or deposited thereon. As discussed above, this insulation layer is typically SiO₂. Next, as shown in FIG. 5, a first metal oxide layer **15,** such as Ta₂O₅, is deposited using chemical vapor deposition techniques, for example. This is followed by the deposition of a second metal oxide layer **17** as illustrated in FIG. 6. As also discussed above, this second metal oxide layer **17** includes a metal oxide with a relatively high dielectric constant such as TiO₂, ZrO₂ and RuO₂. Again, such a metal oxide is preferably TiO₂.

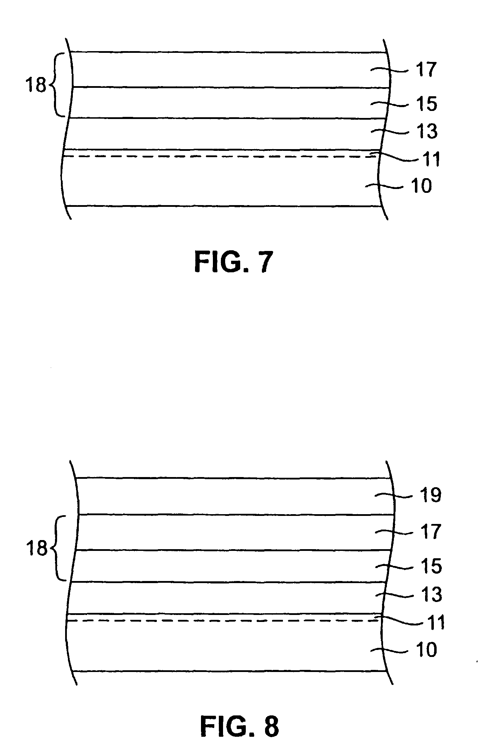

The first and second metal oxide layers **15** and **17** make up the high- composite dielectric stack **18.** Furthermore, it is this high dielectric second metal oxide layer **17** which will substantially block the reduction of the metal oxide of the first metal oxide layer **15** by the metal of the subsequently deposited metal nitride layer **19,** shown in FIG. 8.

Additionally, as shown in FIG. 7, a second SiO₂ layer **11** may be grown before the metal nitride layer **19** is deposited. This second silicon dioxide layer **11** is grown by diffusing oxygen through the first and second metal oxide layers **15, 17** and the insulation layer **13** during an anneal in an oxidizing atmosphere. Also, the growth of the second SiO₂ layer **11** occurs in near equilibrium condition and thus has excellent structural properties. This second SiO₂ layer **11** growth results in a stress-free and planar interface with desirable interfacial and electrical properties.

Many modifications and other embodiments of the invention will come to the mind of one skilled in the art having the benefit of the teachings presented in the foregoing descriptions and the associated drawings. Therefore, it is to be understood that the invention is not to be limited to the specific embodiments disclosed, and that modifications and embodiments are intended to be included within the scope of the appended claims.

## Claims

1. A semiconductor device comprising:
a semiconductor substrate;
a tantalum oxide layer adjacent said substrate;
a metal oxide layer on said tantalum oxide layer opposite said semiconductor substrate; and
a metal nitride layer on said metal oxide layer opposite said tantalum oxide layer, said metal nitride layer comprising a metal capable of reducing said tantalum oxide layer;
said metal oxide layer substantially blocking reduction of said tantalum oxide layer by said metal of said metal nitride layer.

2. A semiconductor device according to claim 1 wherein said tantalum oxide layer comprises tantalum pentoxide, and/or wherein said metal oxide layer comprises titanium oxide, or said metal oxide layer comprises at least one of titanium oxide, zirconium oxide, and ruthenium oxide, and/or wherein said metal nitride layer comprises titanium nitride, and/or wherein said metal oxide layer has a dielectric constant greater than about 25.

3. A semiconductor device according to claim 1 wherein said substrate comprises silicon; and wherein said substrate has a channel region therein beneath said tantalum oxide layer, and/or wherein the device further comprises a silicon oxide layer between said substrate and said tantalum oxide layer, and/or wherein said substrate and said silicon oxide layer define an interface; and wherein respective regions of said substrate and said silicon oxide layer adjacent said interface are substantially stress-free.

4. A semiconductor device according to claim 1 further comprising a silicon oxide layer between said substrate and said tantalum oxide layer; wherein said substrate and said silicon oxide layer define an interface; and wherein respective regions of said substrate and said silicon oxide layer adjacent said interface are substantially stress-free.

5. A semiconductor device according to claim 1 further comprising a conductive layer between said substrate and said tantalum oxide layer to define a capacitor with said metal nitride layer, and/or wherein said conductive layer comprises a metal.

6. A semiconductor device according to claim 5, further comprising a silicon oxide layer between said conductive layer and said tantalum oxide layer, and/or an insulating layer between said substrate and said conductive layer.

7. A semiconductor device comprising:
a semiconductor substrate;
a tantalum oxide layer adjacent said substrate;
a titanium oxide layer on said tantalum oxide layer and opposite said semiconductor substrate; and
a titanium nitride layer on said titanium oxide layer opposite said tantalum oxide layer.

8. A semiconductor device according to claim 7, wherein said titanium oxide layer has a dielectric constant of about 25, and/or wherein said substrate comprises silicon; and wherein said substrate has a channel region therein beneath said tantalum oxide layer, and/or further comprising a silicon oxide layer between said substrate and said tantalum oxide layer.

9. A semiconductor device according to claim 8 wherein said substrate and said silicon oxide layer define an interface; and wherein respective regions of said substrate and said silicon oxide layer adjacent said interface are substantially stress-free, and/or wherein the device further comprises a silicon oxide layer between said substrate and said tantalum oxide layer; wherein said substrate and said silicon oxide layer define an interface; and wherein respective regions of said substrate and said silicon oxide layer adjacent said interface are substantially stress-free, and/or wherein the device further comprises a conductive layer between said substrate and said tantalum oxide layer to define a capacitor with said metal nitride layer, and/or wherein said conductive layer comprises a metal, and/or wherein the device further comprises a silicon oxide layer between said conductive layer and said tantalum oxide layer, and/or an insulating layer between said substrate and said conductive layer.

10. An integrated circuit device comprising:
a semiconductor substrate;
a first metal oxide layer adjacent said substrate, said first metal oxide layer including a metal oxide which is susceptible to reduction;
a second metal oxide layer on said dielectric oxide layer opposite said semiconductor substrate; and
a metal nitride layer on said second metal oxide layer opposite said first metal oxide layer, said metal nitride layer comprising a metal capable of reducing said metal oxide of said first metal oxide layer;
said second metal oxide layer substantially blocking reduction of said metal oxide by said metal of said metal nitride layer.

11. An integrated circuit device according to claim 10, wherein said metal oxide of said first metal oxide layer comprises at least one of tantalum oxide and tantalum pentoxide, and/or wherein said second metal oxide layer comprises at least one of titanium oxide, zirconium oxide, and ruthenium oxide, and/or wherein said metal nitride layer comprises titanium nitride, and/or wherein said metal oxide layer has a dielectric constant greater than about 25.
